# EUROPEAN PATENT SPECIFICATION

(11) **EP 0 768 713 B1**
(45) Date of publication and mention of the grant of the patent: **08.03.2006**
(21) Application number: 96306877.0
(22) Date of filing: 20.09.1996
(51) Int. Cl.: H01L 27/02

(54) **Circuit including protection means**
Schaltung mit einem Schutzmittel
Circuit comprenant des moyens de protection

(30) Priority: 20.09.1995 US 4054
(43) Date of publication of application: 16.04.1997
(73) Proprietor: TEXAS INSTRUMENTS INCORPORATED, Dallas Texas 75265 (US)
(72) Inventor: Chen, Julian Zhiliang, Dallas, Texas 75231 (US); Zhang, Xin Yi, California 94305 (US); Vrotsos, Thomas A., Richardson, Texas 75080 (US); Amerasekera, Ajith, Plano, Texas 75023 (US)
(74) Representative: Legg, Cyrus James Grahame

(56) References cited:
- EP-A- 0 413 054
- EP-A- 0 583 105
- US-A- 5 166 764
- US-A- 5 170 240
- CHEN J Z ET AL: "DESIGN AND LAYOUT OF A HIGH ESD PERFORMANCE NPN STRUCTURE FOR SUBMICRON BICMOS/BIPOLAR CIRCUITS" 30 April 1996 , 1996 IEEE INTERNATIONAL RELIABILITY PHYSICS PROCEEDINGS, 34TH. ANNUAL: DALLAS, APR. 30 - MAY 2, 1996, NR. SYMP. 34, PAGE(S) 227 - 232 , INSTITUTE OF ELECTRICAL AND ELECTRONICS ENGINEERS XP000626581 * the whole document *

## Description

### FIELD OF THE INVENTION

This invention relates to electronic circuits, and more particularly relates to electrostatic discharge (ESD) protection circuits.

### BACKGROUND OF THE INVENTION

The use of electrostatic discharge (ESD) protection circuits to protect input and output circuitry from ESD is well known, as taught in prior art U.S. Patent No. 5,268,588; U.S. Patent No. 4,896,243; U.S. Patent No. 5,077,591; U.S. Patent No. 5,060,037; U.S. Patent No. 5,290,317; U.S. Patent No. 5,225,702 and U.S. Patent No. 5,290,724 all assigned to Texas Instruments Incorporated, the assignee herein.

European Patent 0 413 054 provides a vertical transistor device for ESD protection. A region of the same conductivity type as the emitter region provides a pinch resistance between the base contact and the base region in addition to a field homogenisation effect.

U.S. Patent 5,166,764 provides a bipolar transistor for ESD protection including floating electrodes to define an equipotential base region to increase the effective size of the transistor.

U.S. Patent 5,170,240 provides a dual-transistor structure for ESD protection with one transistor being an input transistor and a second transistor being a trigger transistor. The two transistors are connected in cascade and have a common collector configuration.

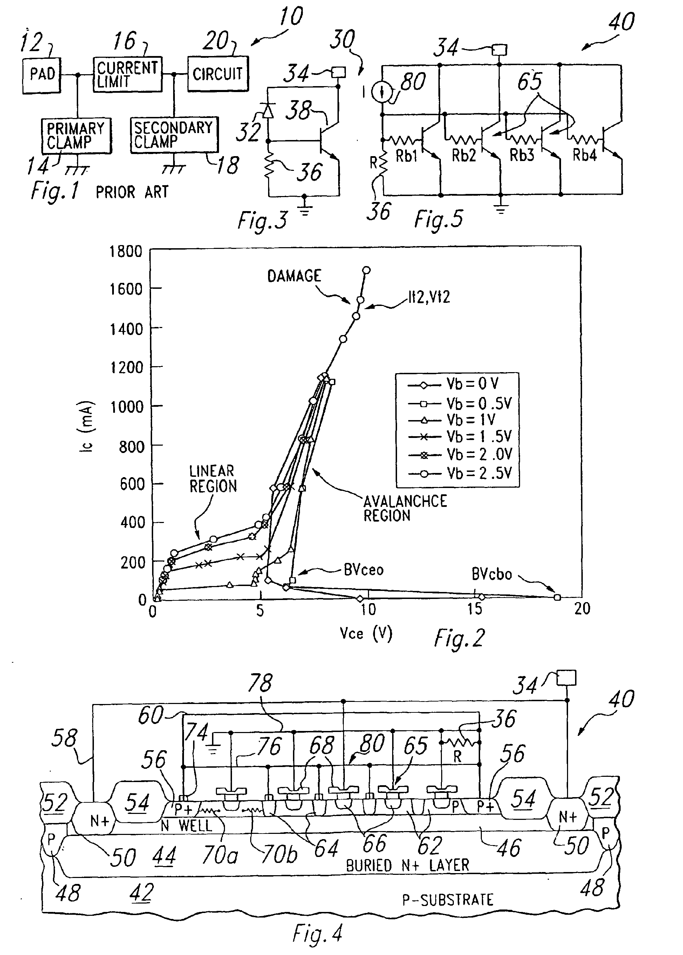

Many ESD protection circuits utilize a two stage protection scheme on circuit inputs as shown in prior art FIG. 1. Typically, the high current pulse of an ESD strike passes through the primary clamp, which clamps the pad voltage. However, this is still too high a voltage for the circuitry to receive, therefore the secondary clamp clamps the voltage to a safe value. The current limit structure restricts the current flow so that the secondary clamp does not have to be excessively large.

As complimentary oxide semiconductor (CMOS) processes evolve to shorter transistor channel lengths and gate oxides, it becomes more difficult to protect both input and output circuits from damage due to ESD. For example, as the gate oxide of transistors become thinner, the breakdown voltage of the gate oxide will become lower than the breakdown voltages of the standard CMOS process flow diffusions. Therefore, the standard prior art ESD clamps will no longer protect the gate oxide from ESD because the gate oxide will fail before the ESD clamp initiates clamping of the ESD pulse.

Prior art primary clamps also suffer from limitations. They exhibit high clamping voltages that provide little headroom for "IR" drops that occur in electrostatic discharge protection circuits due to the large currents and small metallization resistance. A primary clamp circuit that could clamp ESD pulses at lower voltage levels would be beneficial.

Output circuits also suffer from low level ESD damage. If the output device evenly breaks down, it absorbs the ESD energy. However, the output device may not turn "ON" completely or evenly, but rather will conduct in localized areas at a voltage value lower than the device breakdown. When this occurs, a "hot spot" is created and the device suffers damage.

Moreover, when NPN transistors are used for ESD protection in sub-micron BiCMOS and CMOS applications, the ESD threshold level typically scales with the length of the emitter finger, and not with the number of provided fingers. For example, 100µm-length emitter NPN's have an ESD threshold of about 3.6-3.9KV for sub-micron BiCMOS processes. As tight pad pitch in VLSI and ULSI products limits the length and size of the protective NPN transistor and establishes the ESD threshold limit, it would be desirable to provide an ESD that meets the challenges of reduced spatial availability, increased voltage threshold, low shunt capacitance and low series resistance, preferably less than about 0.5ohm on input and output pads.

The present invention provides a multiple emitter electrostatic discharge circuit protection structure, comprising a first semiconductor layer having a first conductivity type, a second semiconductor layer having a second conductivity type opposite that of said first semiconductor layer, disposed in substantially overlying relation to said first semiconductor layer, a third semiconductor layer of the second conductivity type, overlying the second semiconductor layer, a plurality of first regions of the second conductivity type, the first regions extending through said third semiconductor layer to electrically connect with the second semiconductor layer, a plurality of second regions laterally spaced from the plurality of first regions, the second regions having the first conductivity type, the second regions.being physically connected to the third semiconductor layer, a plurality of third regions and a plurality of fourth regions interposed between the second regions, the third and fourth regions being arranged alternately with each other, said third and fourth regions having the first conductivity type, with the fourth regions being more heavily doped than the third regions, the fourth regions being electrically connected to the second regions, a plurality of laterally spaced fifth regions each at least partially within a respective third region, the fifth regions each forming an emitter region having the second conductivity type.

### BRIEF DESCRIPTION OF THE DRAWINGS

Further features and advantages of the present invention will become apparent from a reading of the specification in conjunction with the drawings, for which like reference characters represent corresponding parts throughout the various views and in which certain aspects of the depicted structures have been exaggerated for clarity, in which:
FIG. 1 is a block diagram illustrating a conventional ESD protection circuit;
FIG. 2 is a graph of NPN transistor base biases;
FIG. 3 is a schematic illustration of an ESD protection circuit in accordance with the present invention;
FIG. 4 is a cross-section of the circuit illustrated schematically in FIG. 3;
FIG. 5 is a further schematic illustration of the ESD protection circuit of the present invention;
FIG. 6 is a cross-section of a Type II ESD circuit;
FIG. 7 is a graph relating threshold voltage for different types of NPN transistor circuits and for numbers of emitter fingers;
FIG. 8 is a graph relating ESD efficiency for different types of NPN transistor circuits and for numbers of emitter fingers; and
FIG. 9 is a cross-section of a Type III ESD circuit.

### DETAILED DESCRIPTION OF PREFERRED EMBODIMENTS

The ESD circuit of the present invention provides the relatively low shunt capacitance (typically <0.5pF) and series resistance (typically <0.5ohm) on circuit input and output pads that are desired for the present and future contemplated generations of sub-micron Bipolar/BiCMOS circuit protection schemes. In order to attain a 4kV ESD threshold in 0.8µm BiCMOS processes, a single 110µm NPN transistor is required. Such an NPN transistor occupies approximately 15µm x 116µm (=1,740µm² of silicon area, thereby rendering an approximately 2.3 V/µm² ESD efficiency (measured in ESD volts per unit of protection area).

As will be explained in greater detail below, the ESD circuit of the present invention provides a higher efficiency, more space efficient ESD circuit that is achieved through uniform turn-on of multi-emitter fingers from an internal Zener diode current source. The Zener diode is also operable to lower the protection circuit trigger voltage from the typical ~18V to ~7V without introducing any additional series impedance into the signal path, thereby rendering an NPN structure that is particularly well suited for protecting Bipolar and CMOS input and output buffers. Surface area requirements for the ESD protection circuit of the present invention amount to only about 39µm x 28.5µm (=1,111µm²) to obtain a 4kV ESD threshold voltage, resulting in an efficiency gain to ~3.6 V/µm² (compared to ∼2.3 v/µm² for typical single emitter designs). The foregoing surface area reduction provides a ~56% reduction in parasitic capacitance, as compared to single emitter designs.

The foregoing difficulties and limitations in prior art ESD's are illustrated in Figure 2, which depicts a typical high current-voltage curve for an NPN transistor having different base biases. By grounding the base, the NPN triggers at collector-base breakdown ("BV") voltage BV_{cbo} and snaps back to the avalanche mode to conduct the high ESD current. However, the base voltage collector-emitter breakdown voltage BV_{ceo} trigger voltage is too high to protect input and output buffers in sub-micron processes. As indicated in Figure 2, when the base is biased, the NPN can enter the avalanche mode without experiencing any snap back. Accordingly, a Zener trigger circuit 30, as illustrated generally in Figure 3, can be incorporated into the proposed protection structure to lower the trigger voltage. The Zener trigger circuit 30 includes a Zener diode 32 that is coupled serially between pad 34 and resistor 36. An anode of the Zener diode 32 is connected to the base terminal of an NPN transistor 38, that is also coupled between the pad 34 and ground. The Zener circuit 30 is operable to reduce power dissipation when used as a primary clamp by shunting current through NPN transistor 38 following breakdown of the Zener diode 32.

The Zener breakdown voltage should be designed to be slightly higher than the power supply voltage so that the protection circuit will not turn "ON" during normal circuit operation. Under an ESD event, when the pad voltage exceeds the Zener breakdown voltage, the Zener diode 32 will conduct current to bias the base to turn "ON" the protection NPN transistor 38.

Prior to development of the present invention, ESD threshold voltage was known only to be scaleable as a function of emitter finger length, as opposed to the number or density of emitter fingers. In accordance with the teachings of the present invention as set forth below, ESD threshold voltage can be scaled in accordance with the provision of a Zener diode and the number of emitter fingers, thereby allowing for considerably more compact and efficient ESD circuits for further reduced geometry devices.

A high efficiency ESD protection circuit 40 having a four emitter NPN structure in accordance with the teachings of the present invention is illustrated in Figure 4. The illustrated circuit 40 was fabricated in a 0.8µm BiCMOS process, it being understood, however, that the principles and teachings of the present invention can be appropriately scaled upwardly or downwardly for use with different processes, such as sub-micron Bipolar. The circuit 40 is comprised of a P-substrate 42 which underlies an N⁺ buried layer 44. The P-substrate is formed from a suitable material, such as boron, that diffuses by way of lattice interstitials.

The N⁺ buried layer is formed from a material, such as antimony, that diffuses by way of lattice vacancies. An N-well 46 overlies the buried N⁺ layer 44 and is doped with a lattice interstitial-diffusing material, such as phosphorous. Relatively narrow P-regions or bands 48 that are doped with boron or other suitable interstitial-diffusing media at typically higher concentrations than that of the P-substrate are positioned adjacent to the ends of the buried N⁺ layer 44 and N-well 46. Relatively narrow N⁺ zones 50, which serve as the collector of the NPN structure of the present invention, extend from the buried N⁺ layer 44, through the N-well 46, to extend above an upper surface of the N-well. A suitable oxide layer 52, such as SiO₂, is developed over the P-regions 48 and is coextensive with the lateral boundary of N⁺ zones 50. Oxide layers 54 are also developed above the N-well 46 so as to be interposed between N⁺ layer 44 and a P⁺ region 56, which serve as the base of the NPN device 40. Thus, the NPN collector/N' zones 50 are electrically isolated from the P⁺ regions/NPN base 56 by the oxide layers 52 & 54, yet are electrically connected to one another and to Pad 34, as indicated by electrical lead line 58. NPN base/P' regions 56 are electrically connected to one another by electrical lead line 60.

Interposed between NPN base/P⁺ regions 56 is an alternating array of an "N+1" number of P-doped sections 62 and "N" number of P⁺ regions 64, where "N" corresponds to the number of NPN emitters 65 to be provided. In the illustrated embodiment, and as will be explained in further detail below, the number of NPN emitters 65 is four. Accordingly, the value of N equals 4. However, it is to be appreciated that the principles and teachings of the present invention are equally applicable to ESD circuit structures having a greater or lesser number of NPN emitters.

Each NPN emitter 65 is comprised of an N+diffusion 66 that underlies, and is connected to, a polysilicon layer 68. For the Type I device shown, the polysilicon layer 68 is configured as a plurality "N+1" of discrete regions so as to permit doping of the P⁺ implant regions 64 in a manner well known in the art. Each intrinsic base of single NPN is connected to an adjacent P⁺ region 56/64 by a pair of extrinsic base resistors 70a & 70b (collectively referred to as Rb1 in Fig. 5), although only one such pair of resistors 70a & 70b is depicted in the drawing for the sake of simplicity. The emitters 65 are separated from one another, and are surrounded by, P⁺ diffusion regions 56/64. All of the P⁺ regions 56/64 are electrically connected to the NPN transistor base contacts 56 by way of a continuous silicide layer 74 over the P⁺ region, as indicated by line 76. Provision of the silicide layer 74, in lieu of metal contacts, increases space efficiency of the circuit, as the layer 74 electrically connects all of the P⁺ diffusion regions to the transistor base. Moreover, use of silicide to make the electrical connection allows for a decrease in spacing between emitter fingers, as bulky metal contacts are not required.

The circuit resistor 36 is connected in parallel to each of the grounded emitter polysilicon regions 68, as indicated by line 78. A Zener diode 80 is formed by the emitter-base junction and serves as the circuit current source and is electrically connected to the lateral N⁺ regions by electrical lead line 58 discussed previously. Internal fabrication of the Zener diode 80 in the same tank as the NPN further increases circuit space efficiency, thereby reducing demand for silicon space.

During an ESD circuit protection event, which occurs when the voltage at pad 34 exceeds the breakdown voltage for the Zener diode 80 (Fig. 4), the Zener diode 80 will conduct current to bias the NPN transistor base 56 and 64 to turn "ON" transistor protection.

For an ESD circuit 40 fabricated in a 0.8µm BiCMOS process, the external base resistance is ~1Kohm formed by a high resistance value layer (typically >~500=1KOhm/square). A current of ~1mA will result in a voltage of ~1V at the base terminal. As the base contacts (by way of the silicide layer 74) are spaced equidistantly from each emitter finger 65, resistance between the emitter and base of each emitter finger is the same (i.e., Rb1 = Rb2 = Rb3 = Rb4 for the 4-emitter circuit schematic illustrated in Figure 5). As indicated in the circuit schematic of Fig. 5 and circuit cross-section of Fig. 4, each emitter finger can be considered to act, in conjunction with the transistor base and collector, as a discrete NPN transistor. Accordingly, discussion in this specification of a plurality of NPN emitter fingers and a parallel array of NPN transistors in the ESD circuit of the present invention is to be construed as being synonymous, as each emitter finger encompasses a vertical N-P-N region. As such, the base-emitter voltage for each emitter finger NPN transistor is the same, resulting in uniform activation of the parallel array of NPN transistors. In contrast, prior art structures do not provide substantially equal base-emitter voltage across each of the emitter fingers. As such, the emitter fingers will have different voltages across them, resulting in non-uniform activation of the NPN transistors, thus reducing ESD protection circuitry efficiency.

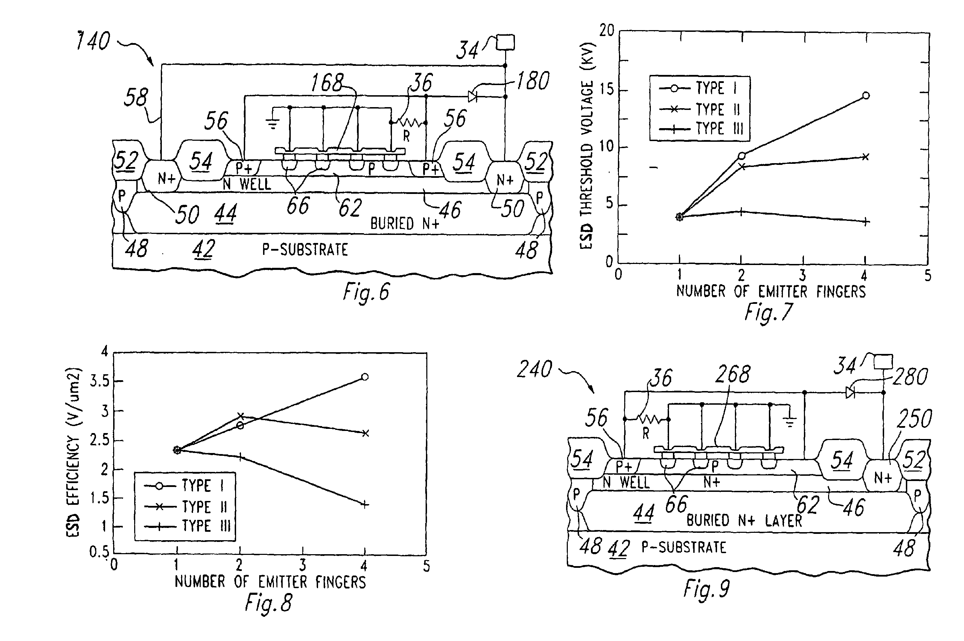

The performance characteristics of the 4-emitter NPN ESD protect in circuit of the present invention supersede those of other ESD circuits. With reference to Figure 6, a 4-emitter Type II ESD circuit 140 is provided not forming part of the claimed invention. This low efficiency design differs from the ESD circuit 40 (Figs. 4 and 5) of the present invention, most notably in having an external (180), rather than internal, current source. Moreover, discrete P⁺ regions 64 (Fig. 4) are not provided to separate transistor emitter legs, as the polysilicon 168 is applied as a continuous layer that does not include windows for P⁺ region deposition. As a consequence, performance and efficiency of the circuit 140 cannot match that of the present invention. These deficiencies are illustrated graphically in Figures 7 and 8, which illustrate both lower threshold voltages and (generally) decreasing efficiency for the NPN structure of both Figure 6 (Type II) and Figure 9 (Type III) not forming part of the claimed invention. As is shown in Figure 9, the Type III circuit arrangement 240 differs from that of the present invention by providing an external Zener diode 280, non-spaced polysilicon 268 (hence, no windows for deposition of P⁺ regions 64 (Fig. 4), and only a single N⁺ transistor collector 250, as opposed to the dual collectors 50 provided in the present invention. Moreover, neither of the Type II (Fig. 6) or Type III (Fig. 9) designs provides a plurality of P⁺ diffusion regions 64,. Accordingly, such region cannot be connected by a silicide layer 74 to base contacts 56. As a result, threshold voltage, efficiency and overall circuit performance suffers as compared to the ESD protection circuit 40 of the present invention. In particular, the Type I circuit 40 (Fig. 4) exhibits more favorable threshold voltage scaling than is possible with either of the Type II or Type III designs, as threshold voltage increases nearly linearly with an increase in the number of transistor emitter fingers. Enhanced Type I threshold voltage performance is attributable to the function of the emitter fingers as a parallel array of four equivalent single emitter NPN transistors having equal, or nearly equal, base resistance values with their respective collectors tied together. Consequently, an ESD event triggers all four (Figs. 4 and 5) NPNs simultaneously.
ESD current will continuously raise the pad voltage until the parallel NPN array enter the avalanche mode to conduct the current with only a 1-2ohm resistance.

The provision of an equal, or nearly equal, base resistance for each of the virtual NPNs is an important attribute that permits for threshold voltage to scale with the number of transistor emitters. In sub-micron Bipolar/BiCMOS processes, the second breakdown voltage (Vt₂) of an NPN is normally higher than is the "snap-back" voltage (Bvceo), as shown in Fig. 2. Equalization of base resistance ensures that all NPNs turn "on" before the voltage across one of the NPNs reaches Vt₂.

Threshold voltage does not scale with the number of emitter fingers for the Type III structure due to the different base resistance values for the emitter fingers. The same holds true for the Type II structure, notwithstanding its symmetrical double collector configuration.

## Claims

1. A multiple emitter electrostatic discharge circuit protection structure, comprising:
a first semiconductor layer (42) having a first conductivity type;
a second semiconductor layer (44) having a second conductivity type opposite that of said first semiconductor layer, disposed in substantially overlying relation to said first semiconductor layer (42);
a third semiconductor layer (46) of the second conductivity type, overlying the second semiconductor layer (44),
a plurality of first regions (50) of the second conductivity type, the first regions extending through said third semiconductor layer to electrically connect with the second (44) semiconductor layer,
a plurality of second regions (56) laterally spaced from the plurality of first regions (50), the second regions having the first conductivity type, the second regions being physically connected to the third semiconductor layer (46),
a plurality of third regions (62) and a plurality of fourth regions (64) interposed between the second regions (56),the third and fourth regions being arranged alternately with each other, said third and fourth regions having the first conductivity type, with the fourth regions being more heavily doped than the third regions, the fourth regions being electrically connected to the second regions,
a plurality of laterally spaced fifth regions (65) each at least partially within a respective third region, the fifth regions each forming an emitter region having the second conductivity type.

2. The protection structure according to claim 1, wherein a first current guiding region of a transistor is formed by said first regions (50), wherein a control region of said transistor is formed by said laterally spaced second regions (56), and wherein a second current guiding region of said transistor is formed by said plurality of laterally spaced fifth regions (65).

3. The protection structure according to claim 2, wherein said transistor is an npn transistor.

4. The protection structure of claim 2, in which the third (62) and fourth (64) regions are arranged in an alternating array, a portion of at least one of the third and fourth regions physically contacting the third semiconductor layer.

5. The protection structure according to claim 4, wherein said alternating array comprises an "N + 1" number of p-doped third regions (62) and an "N" number of p+ regions (64), where "N" corresponds to the number of transistor emitters to be provided.

6. The protection structure according to any preceding claim, wherein said third semiconductor layer (46) is doped at one of a different dopant composition or concentration than said second semiconductor layer (44).

7. The protection structure according to any preceding claim, wherein an oxide region (54) is interposed between said first regions (50) and said second regions (56).

## Revendications

1. Structure de protection d'un circuit de décharge électrostatique à émetteurs multiples comprenant :
une première couche semi-conductrice (42) ayant un premier type de conductivité ;
une deuxième couche semi-conductrice (44) ayant un deuxième type de conductivité opposé à celui de ladite première couche semi-conductrice, disposée de façon sensiblement superposée par rapport à ladite première couche semi-conductrice (42) ;
une troisième couche semi-conductrice (46) du deuxième type de conductivité, superposée sur la deuxième couche semi-conductrice (44),
une pluralité de premières régions (50) du deuxième type de conductivité, les premières régions s'étendant à travers ladite troisième couche semi-conductrice afin de se connecter électriquement à la deuxième couche semi-conductrice (44),
une pluralité de deuxièmes régions (56) espacées latéralement de la pluralité de premières régions (50), les deuxièmes régions étant du premier type de conductivité, les deuxièmes régions étant connectées physiquement à la troisième couche semi-conductrice (46),
une pluralité de troisièmes régions (62) et une pluralité de quatrièmes régions (64) interposées entre les deuxièmes régions (56), les troisièmes et quatrièmes régions étant agencées alternativement les unes avec les autres, lesdites troisièmes et quatrièmes régions étant du premier type de conductivité, les quatrièmes régions étant plus fortement dopées que les troisièmes régions, les quatrièmes régions étant connectées électriquement aux deuxièmes régions,
une pluralité de cinquièmes régions (65) espacées latéralement étant chacune au moins partiellement à l'intérieur d'une troisième région respective, les cinquièmes régions formant chacune une région émettrice du deuxième type de conductivité.

2. Structure de protection selon la revendication 1, dans laquelle une première région guidant le courant d'un transistor est formée par lesdites premières régions (50), dans laquelle une région de contrôle dudit transistor est formée par lesdites deuxièmes régions (56) espacées latéralement et dans laquelle une deuxième région guidant le courant dudit transistor est formée par ladite pluralité de cinquièmes régions (65) espacées latéralement.

3. Structure de protection selon la revendication 2, dans laquelle ledit transistor est un transistor npn.

4. Structure de protection selon la revendication 2, dans laquelle les troisièmes (62) et quatrièmes (64) régions sont agencées en une matrice alternative, une partie d'au moins une des troisièmes et quatrièmes régions étant en contact physique avec la troisième couche semi-conductrice.

5. Structure de protection selon la revendication 4, dans laquelle ladite matrice alternative comprend un nombre « N+1 » de troisièmes régions (62) dopées p et un nombre « N » de régions (64) p+ dans laquelle « N » correspond au nombre d'émetteurs de transistor à fournir.

6. Structure de protection selon l'une quelconque des revendications précédentes, dans laquelle ladite troisième couche semi-conductrice (46) est dopée avec un dopant ayant une composition ou une concentration différentes de celles de ladite deuxième couche semi-conductrice (44).

7. Structure de protection selon l'une quelconque des revendications précédentes, dans laquelle une région oxyde (54) est interposée entre lesdites premières régions (50) et lesdites deuxièmes régions (56).

## Patentansprüche

1. Schutzstruktur-Schaltung für elektrostatische Entladung mit mehreren Emittern, welche aufweist:
eine erste Halbleiterschicht (42) eines ersten Leitfähigkeitstyps,
eine zweite Halbleiterschicht (44) eines zweiten Leitfähigkeitstyps, der demjenigen der ersten Halbleiterschicht entgegengesetzt ist, wobei sie im Wesentlichen über der ersten Halbleiterschicht (42) liegt,
eine dritte Halbleiterschicht (46) des zweiten Leitfähigkeitstyps, die über der zweiten Halbleiterschicht (44) liegt,
mehrere erste Bereiche (50) des zweiten Leitfähigkeitstyps, wobei sich die ersten Bereiche durch die dritte Halbleiterschicht erstrecken, so dass eine elektrische Verbindung mit der zweiten Halbleiterschicht (44) hergestellt wird,
mehrere zweite Bereiche (56), die seitlich von den mehreren ersten Bereichen (50) beabstandet sind, wobei die zweiten Bereiche den ersten Leitfähigkeitstyp aufweisen und die zweiten Bereiche körperlich mit der dritten Halbleiterschicht (46) verbunden sind,
mehrere dritte Bereiche (62) und mehrere vierte Bereiche (64), die zwischen den zweiten Bereichen (56) angeordnet sind, wobei die dritten und vierten Bereiche alternierend angeordnet sind, die dritten und die vierten Bereiche den ersten Leitfähigkeitstyp aufweisen, die vierten Bereiche stärker dotiert sind als die dritten Bereiche und die vierten Bereiche elektrisch mit den zweiten Bereichen verbunden sind, und
mehrere seitlich beabstandete fünfte Bereiche (65), die jeweils zumindest teilweise innerhalb eines jeweiligen dritten Bereichs liegen, wobei die fünften Bereiche jeweils einen Emitterbereich des zweiten Leitfähigkeitstyps bilden.

2. Schutzstruktur nach Anspruch 1, wobei ein erster stromführender Bereich eines Transistors durch die ersten Bereiche (50) gebildet ist, ein Steuerbereich des Transistors durch die seitlich beabstandeten zweiten Bereiche (56) gebildet ist und ein zweiter stromführender Bereich des Transistors durch die mehreren seitlich beabstandeten fünften Bereiche (65) gebildet ist.

3. Schutzstruktur nach Anspruch 2, wobei der Transistor ein npn-Transistor ist.

4. Schutzstruktur nach Anspruch 2, wobei die dritten Bereiche (62) und die vierten Bereiche (64) in einer alternierenden Mehrfachanordnung eingerichtet sind, wobei ein Teil der dritten und/oder der vierten Bereiche körperlich in Kontakt mit der dritten Halbleiterschicht steht.

5. Schutzstruktur nach Anspruch 4, wobei die alternierende Mehrfachanordnung eine Anzahl "N + 1" p-dotierter dritter Bereiche (62) und eine Anzahl "N" von (p+)-Bereichen (64) aufweist, wobei "N" der Anzahl der bereitzustellenden Transistoremitter entspricht.

6. Schutzstruktur nach einem der vorstehenden Ansprüche, wobei die dritte Halbleiterschicht (46) mit einer anderen Dotierungszusammensetzung oder einer anderen Dotierungskonzentration als die zweite Halbleiterschicht (44) dotiert ist.

7. Schutzstruktur nach einem der vorstehenden Ansprüche, wobei ein Oxidbereich (54) zwischen den ersten Bereichen (50) und den zweiten Bereichen (56) angeordnet ist.
